# EUROPEAN PATENT APPLICATION

(11) **EP 4 764 548 A1**
(43) Date of publication of application: **24.06.2026**
(21) Application number: 25822493.0
(22) Date of filing: 12.05.2025
(51) Int. Cl.: G01R 31/392, G01R 31/367, G01R 33/02, H01M 50/105

(54) **BATTERY DIAGNOSIS DEVICE AND OPERATING METHOD THEREOF**

(30) Priority: 14.06.2024 KR 20240077710
(71) Applicant: LG Energy Solution, Ltd., Seoul 07335 (KR)
(72) Inventor: KIM, Jin Woong, Daejeon 34122 (KR); LEE, Hong Kyung, Dalseong-gun Daegu 42988 (KR); LEE, Min Gyu, Cheonan-si Chungcheongnam-do 31080 (KR); CHOI, Jong Seong, Daejeon 34122 (KR); KWON, Bong Keun, Daejeon 34122 (KR); PARK, Hyung June, Daejeon 34122 (KR)
(74) Representative: Goddar, Heinz J.
(86) International application number: PCT/KR2025/006391
(87) International publication number: WO 2025/258863

(57) **Abstract**

A battery diagnosis device according to an embodiment disclosed in this document may include an interface configured to acquire a magnetic field image of a battery cell and one or more processors configured to generate magnetic field linear data corresponding to a magnetic field intensity at a specific location of the battery cell based on the magnetic field image and diagnose an abnormality of the battery cell based on the magnetic field linear data.

## Description

### TECHNICAL FIELD

### Cross-reference to Related Applications

This application claims priority from Korean Patent Application No. 10-2024-0077710, filed on June 14, 2024, the disclosures of which are incorporated by reference herein.

### Technical Field

Embodiments disclosed in this document relate to a battery diagnosis device and an operating method thereof.

### BACKGROUND ART

Recently, research and development on secondary batteries has been actively conducted. Here, secondary batteries are batteries that can be charged and discharged, and may be interpreted including both conventional Ni/Cd batteries, Ni/MH batteries, and recent lithium ion batteries. Among secondary batteries, lithium ion batteries have the advantage of having much higher energy density than conventional Ni/Cd batteries and Ni/MH batteries, etc. In addition, lithium ion batteries may be manufactured to be small and lightweight, and thus lithium ion batteries are used as power sources for mobile devices. Recently, the scope of use of the lithium ion batteries has expanded to include a power source for electric vehicles, and the lithium ion batteries are attracting attention as a next-generation energy storage medium.

In order to effectively use battery cells, it is necessary to accurately determine defects occurring in the battery cells, and a method of analyzing an X-ray or computed tomography (CT) photographing result is used as a conventional method for determining the defects occurring in the battery cells. However, there was a problem that it took a long time to analyze the X-ray or CT photographing result and that it was only possible to determine some of the various defects that may occur in the battery cells.

In addition, according to the conventional magnetic field imaging (MFI) technology that observes the change in magnetic field formed during charging and discharging of battery cells, there was a problem in that only the type of defect that occurred in the battery cells could be determined, but not the level of the defect could not be determined. For example, when approximately 10% of the electrode tab is torn in a first battery cell and approximately 70% of the electrode tab is torn in a second battery cell, according to conventional magnetic field imaging technology, there was a problem in that it was only possible to analyze that a defect (electrode tab tear) occurred in the first battery cell and the second battery cell, but it was not possible to analyze that different levels of defect (electrode tab tear) occurred in the first battery cell and the second battery cell.

### DISCLOSURE OF THE INVENTION

### TECHNICAL PROBLEM

Embodiments disclosed in this document provide a battery diagnosis device and a battery diagnostic method for analyzing a defect occurring in a battery cell in a nondestructive manner.

Embodiments disclosed in this document provide a battery diagnosis device and a battery diagnostic method for analyzing a level of the defect occurring in a battery cell.

Embodiments disclosed in this document provide a battery diagnosis device and a battery diagnostic method for analyzing a defect occurring in a battery cell in real time.

The technical problems of the embodiments disclosed in this document are not limited to the technical problems mentioned above, and other technical problems that are not mentioned may be clearly understood by those skilled in the art from the descriptions below.

### TECHNICAL SOLUTION

A battery diagnosis device according to an embodiment disclosed in this document includes an interface configured to acquire a magnetic field image of a battery cell and one or more processors configured to generate magnetic field linear data corresponding to a magnetic field intensity at a specific location of the battery cell based on the magnetic field image and diagnose an abnormality of the battery cell based on the magnetic field linear data.

In the battery diagnosis device according to an embodiment disclosed in this document, the one or more processors may be configured to determine a monitoring area including the specific location on the magnetic field image and calculate the magnetic field linear data by referring to the magnetic field intensity in the monitoring area.

In the battery diagnosis device according to an embodiment disclosed in this document, the one or more processors may be configured to calculate the magnetic field linear data by referring to a plurality of first displacement magnetic field intensities to a plurality of n-th displacement magnetic field intensities of a first displacement to an n-th displacement along a reference direction within the monitoring area.

In the battery diagnosis device according to an embodiment disclosed in this document, the one or more processors may be configured to acquire a k-th representative magnetic field intensity corresponding to a k-th displacement along the reference direction within the monitoring area based on a plurality of k-th displacement magnetic field intensities of the k-th displacement, and calculate the magnetic field linear data by referring to a first representative magnetic field intensity to an n-th representative magnetic field intensity including the k-th representative magnetic field intensity.

In the battery diagnosis device according to an embodiment disclosed in this document, the one or more processors may be configured to calculate the magnetic field linear data based on at least some of a first magnetic field component image to a third magnetic field component image included in the magnetic field image, and a first magnetic field component to a third magnetic field component that respectively correspond to the first magnetic field component image to the third magnetic field component image may be orthogonal to one another.

In the battery diagnosis device according to an embodiment disclosed in this document, the one or more processors may be configured to input the magnetic field linear data into a defect level estimation model, and diagnose an abnormality of the battery cell based on an estimated defect level output from the defect level estimation model.

In the battery diagnosis device according to an embodiment disclosed in this document, the defect level estimation model may be configured to output an estimated defect level for training corresponding to magnetic field linear data for training when the magnetic field linear data for training is acquired, and output the estimated defect level in a state where at least some of parameters of the defect level estimation model are updated based on an error generated using the estimated defect level for training and a correct defect level corresponding thereto.

In the battery diagnosis device according to an embodiment disclosed in this document, the one or more processors may be configured to input the magnetic field image into a defect type estimation model, and diagnose an abnormality of the battery cell based on the estimated defect level and an estimated defect type output from the defect type estimation model.

A battery diagnosis method according to an embodiment disclosed in this document includes an operation of acquiring a magnetic field image of a battery cell, an operation of generating magnetic field linear data corresponding to a magnetic field intensity at a specific location of the battery cell based on the magnetic field image, and an operation of diagnosing an abnormality of the battery cell based on the magnetic field linear data.

In the battery diagnosis method according to an embodiment disclosed in this document, the operation of calculating the magnetic field linear data may include an operation of determining a monitoring area including the specific location on the magnetic field image and calculating the magnetic field linear data by referring to the magnetic field intensity in the monitoring area.

In the battery diagnosis method according to an embodiment disclosed in this document, the operation of calculating the magnetic field linear data may include an operation of calculating the magnetic field linear data by referring to a plurality of first displacement magnetic field intensities to a plurality of n-th displacement magnetic field intensities of a first displacement to an n-th displacement along a reference direction within the monitoring area.

In the battery diagnosis method according to an embodiment disclosed in this document, the operation of calculating the magnetic field linear data may include an operation of acquiring a k-th representative magnetic field intensity corresponding to a k-th displacement along the reference direction within the monitoring area based on a plurality of k-th displacement magnetic field intensities of the k-th displacement, and calculating the magnetic field linear data by referring to a first representative magnetic field intensity to an n-th representative magnetic field intensity including the k-th representative magnetic field intensity.

In the battery diagnosis method according to an embodiment disclosed in this document, the operation of calculating the magnetic field linear data may include an operation of calculating the magnetic field linear data based on at least some of a first magnetic field component image to a third magnetic field component image included in the magnetic field image, and a first magnetic field component to a third magnetic field component that respectively correspond to the first magnetic field component image to the third magnetic field component image may be orthogonal to one another.

In the battery diagnosis method according to an embodiment disclosed in this document, the operation of diagnosing the abnormality of the battery cell may include an operation of inputting the magnetic field linear data into a defect level estimation model, and diagnosing an abnormality of the battery cell based on an estimated defect level output from the defect level estimation model.

The battery diagnosis method according to an embodiment disclosed in the present document may further include, prior to the operation of diagnosing the abnormality of the battery cell, an operation of inputting magnetic field linear data for training into the defect level estimation model, generating an error using an estimated defect level for training output from the defect level estimation model and a correct defect level corresponding thereto, and updating at least some of parameters of the defect level estimation model based on the error.

In the battery diagnosis method according to an embodiment disclosed in this document, the operation of diagnosing the abnormality of the battery cell may include an operation of inputting the magnetic field image into a defect type estimation model, and diagnosing the abnormality of the battery cell based on the estimated defect level and an estimated defect type output from the defect type estimation model.

### ADVANTAGEOUS EFFECTS

According to embodiments disclosed in this document, a battery diagnosis device and a battery diagnostic method for analyzing a defect occurring in a battery cell in a nondestructive manner can be provided.

According to embodiments disclosed in this document, a battery diagnosis device and a battery diagnostic method for analyzing a level of the defect occurring in a battery cell can be provided.

According to embodiments disclosed in this document, a battery diagnosis device and a battery diagnostic method for analyzing a defect occurring in a battery cell in real time can be provided.

The technical problems of the embodiments disclosed in this document are not limited to the technical problems mentioned above, and other technical problems that are not mentioned may be clearly understood by those skilled in the art from the descriptions below.

### BRIEF DESCRIPTION OF THE DRAWINGS

FIG. 1 is a block diagram of a battery diagnosis device according to an embodiment.
FIGS. 2a and 2b are diagrams schematically illustrating a magnetic field sensor array and magnetic field images.
FIGS. 3a and 3b are diagrams for describing magnetic field images and magnetic field linear data.
FIGS. 4a to 7b are diagrams for describing various defect levels of a battery cell and the corresponding magnetic field linear data.
FIG. 8 is a flowchart of the operation of a battery diagnosis device according to an embodiment.
FIG. 9 illustrates a computing system that executes an operating method of a battery diagnosis device according to an embodiment.

### MODE FOR CARRYING OUT THE INVENTION

Hereinafter, some embodiments described in this document are described with reference to the accompanying drawings. However, this is not intended to limit the present technology to a specific embodiment, but should be understood to include various modifications, equivalents, and/or alternatives of the embodiments of the present technology.

It should be understood that various embodiments of this document and the terminology used therein are not intended to limit the technical features described in this document to specific embodiments, but rather to encompass various modifications, equivalents, or alternatives of the embodiments. In connection with the description of the drawings, similar reference numerals may be used for similar or related components. The singular form of a noun corresponding to an item may include one or more of said item, unless the relevant context clearly indicates otherwise.

In this document, each of phrases "A or B", "at least one of A and B", "at least one of A or B", "A, B, or C", "at least one of A, B, and C", and "at least one of A, B, or C" may include any one of the items listed together in that phrase among the phrases, or all possible combinations thereof. Terms such as "first", "second", or "firstly" or "secondly" may be used merely to distinguish one component from another, and, unless otherwise stated, do not limit the elements in any other respect (e.g., importance or order).

In this document, when a component (e.g., a first component) is referred to as being "coupled", "connected", or "joined" to another component (e.g., a second component), with or without the terms "functionally" or "communicatively", it means that the component can be connected to the other component directly (e.g., in a wired manner), wirelessly, or through a third component.

According to various embodiments, each component (e.g., a module or a program) of the components described above may include one or more entities, and some of the multiple entities may be separated and placed in other components. According to various embodiments, one or more of the components described above among the components or operations may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed adding one or more other operations.

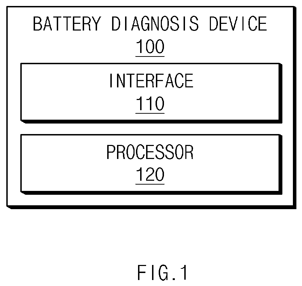

FIG. 1 is a block diagram of a battery diagnosis device according to an embodiment.

Referring to FIG. 1, a battery diagnostic device 100 may include an interface 110 and one or more processors 120.

According to an embodiment, the interface 110 may acquire a magnetic field image of a battery cell.

According to an embodiment, a magnetic field image may be generated by sensing a magnetic field formed as current is applied to a battery cell by a magnetic field sensor array, and the interface 110 may acquire the corresponding magnetic field image.

According to an embodiment, a battery cell that is a target for diagnosing an abnormality by the battery diagnostic device 100 according to an embodiment disclosed in this document may be a pouch cell. However, a pouch cell is merely an example for helping understanding, and the target for diagnosing the abnormality by the battery diagnostic device 100 according to an embodiment disclosed in this document is not limited to the pouch cell. For example, the battery diagnosis device 100 according to an embodiment disclosed in this document may diagnose an abnormality even for a cylindrical battery cell or a prismatic cell.

According to an embodiment, a magnetic field image acquired by the interface 110 according to an embodiment disclosed in this document may include at least some of a first magnetic field component image to a third magnetic field component image. For example, the magnetic field image may include the second magnetic field component image. As another example, the magnetic field image may include the first magnetic field component image to the third magnetic field component image.

In this case, a first magnetic field component corresponding to the first magnetic field component image, a second magnetic field component corresponding to the second magnetic field component image, and a third magnetic field component corresponding to the third magnetic field component image may be orthogonal to one another. For example, a first magnetic field component Bₓ, a second magnetic field component B_{y}, and a third magnetic field component B_{z} may be components corresponding to the x-axis, y-axis, and z-axis of a rectangular coordinate system. As another example, a first magnetic field component Bᵣ, a second magnetic field component B_{θ}, and a third magnetic field component B_{z} may be components corresponding to the R-axis, the θ-axis, and the z-axis of a cylindrical coordinate system.

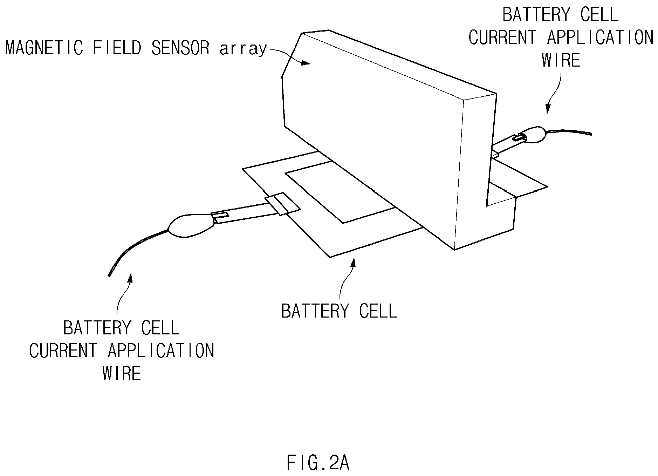

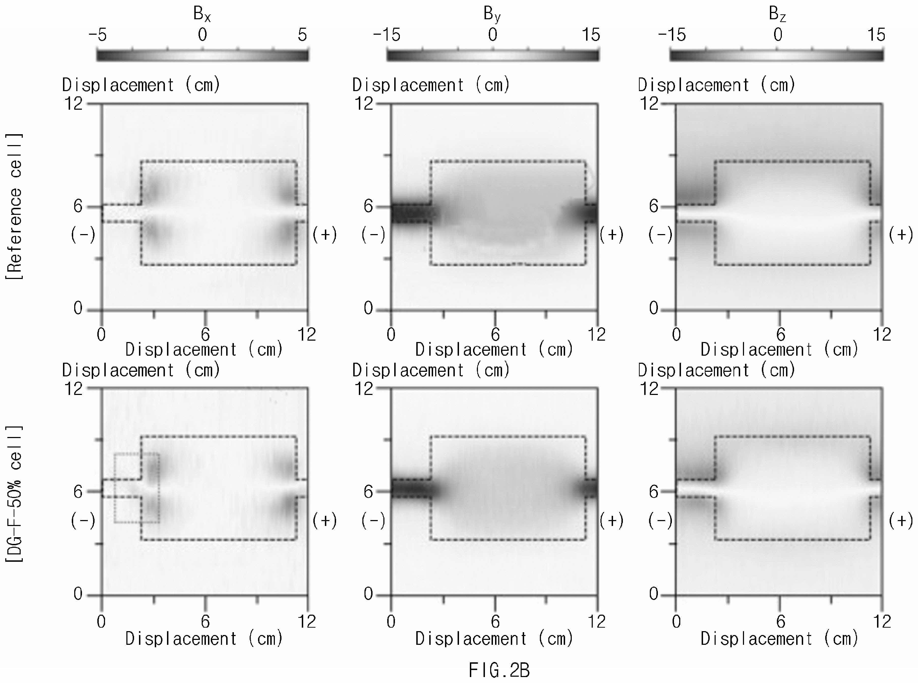

FIGS. 2a and 2b schematically illustrate a magnetic field sensor array and magnetic field images.

Referring to FIG. 2a, a magnetic field may be formed as current is applied to a battery cell in a state where a tab connected to an electrode of a battery cell and a battery cell current application wire are connected to each other, and a magnetic field image may be generated as the magnetic field sensor array senses the magnetic field.

In addition, referring to FIG. 2b, it can be confirmed that magnetic field images for a normal battery cell (reference cell) and a defective battery cell (e.g., a DG-F-50% cell). Specifically, it can be confirmed that, for a normal battery cell (reference cell), a first magnetic field component image to a third magnetic field component image that respectively correspond to the first magnetic field component Bₓ to the third magnetic field component B_{z}, and it can be confirmed that, for a defective battery cell (DG-F-50% cell), a first magnetic field component image to a third magnetic field component image that respectively correspond to the first magnetic field component Bₓ to the third magnetic field component B_{z}.

According to an embodiment, the processor 120 may diagnose an abnormality of the battery cell based on the magnetic field image.

The processor 120 described above may be implemented as one processor or separate processors. Here, the processor may execute software to control at least one other component (e.g., hardware or software component) of the battery diagnosis device 100 and perform various data processing or computations.

According to an embodiment, the battery diagnosis device 100 may transmit a battery diagnosis result to an external device (e.g., a cloud server or a user terminal). Here, the cloud server may provide a service for providing the battery diagnosis result to each of a plurality of users. In addition, the user terminal may include a terminal such as a personal computer (PC) or a smartphone. As an example, the battery diagnosis device 100 may provide information on an abnormal battery cell to a user terminal through a communication unit (not shown), and may also provide information on an abnormal battery cell through a display equipped in a vehicle or charger.

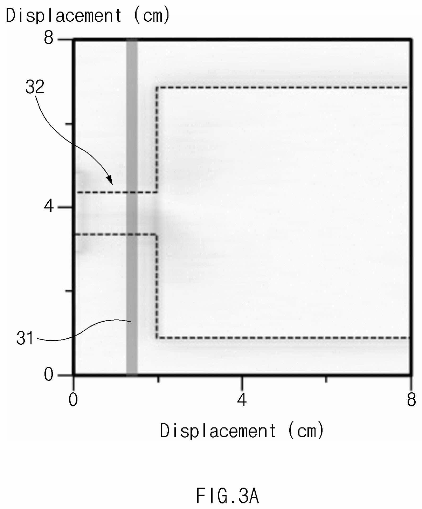

Hereinafter, various embodiments in which the processor 120 diagnoses an abnormality of a battery cell will be described with reference to FIGS. 3a to 7b.

According to an embodiment, the processor 120 may calculate magnetic field linear data corresponding to a magnetic field intensity at a specific location of the battery cell based on a magnetic field image, and diagnose the abnormality of the battery cell based on the magnetic field linear data.

According to an embodiment, the processor 120 may calculate the magnetic field linear data based on at least some of the first magnetic field component image to the third magnetic field component image included in the magnetic field image. For example, the processor 120 may calculate magnetic field linear data based on the first magnetic field component image. As another example, the processor 120 may calculate the magnetic field linear data corresponding to the second magnetic field component based on the second magnetic field component image, and calculate magnetic field linear data corresponding to the third magnetic field component based on the third magnetic field component image.

According to an embodiment, the processor 120 may determine a monitoring area including a specific location on a magnetic field image, and calculate derive magnetic field linear data by referring to the magnetic field intensity in the monitoring area.

According to an embodiment, the processor 120 may determine an area having a predetermined reference width based on the specific location on the magnetic field image as the monitoring area. For example, the processor 120 may determine a strip having a predetermined reference width based on a specific location (e.g., a transverse displacement of 5 cm) on the magnetic field image as the monitoring area.

In order to help understanding the monitoring area, an example will be described with reference to FIG. 3a. Referring to FIG. 3a, a monitoring area 31 may have a predetermined reference width (e.g., 0.3 cm) based on a specific location (e.g., 1.3 cm) of a transverse displacement on the magnetic field image. In this case, the specific location and/or the monitoring area 31 may be a location and/or area where a defect mainly occurs in the battery cell. For example, the specific location may be a location corresponding to an electrode tab 32 of the battery cell, and the monitoring area 31 may be an area including a part of the electrode tab 32 of the battery cell.

According to an embodiment, the processor 120 may calculate magnetic field linear data by referring to a plurality of first displacement magnetic field intensity to a plurality of n-th displacement magnetic field intensities of a first displacement to an n-th displacement along a reference direction within the monitoring area 31 including the specific location. For example, on the magnetic field image of FIG. 3a, the processor 120 may calculate magnetic field linear data by referring to the magnetic field intensity from the first displacement (e.g., 0 cm) to the n-th displacement (e.g., 8 cm) along the longitudinal direction, which is the reference direction, within the monitoring area 31 including a specific location (e.g., 1.3 cm) among the transverse displacements. For example, the processor 120 may calculate magnetic field linear data by referring to the magnetic field intensity from a plurality of first displacement magnetic field intensities corresponding to the first displacement (e.g., 0 cm) along the longitudinal direction to a plurality of n-th displacement magnetic field intensities corresponding to the n-th displacement (e.g., 8 cm) along the longitudinal direction, on the magnetic field image.

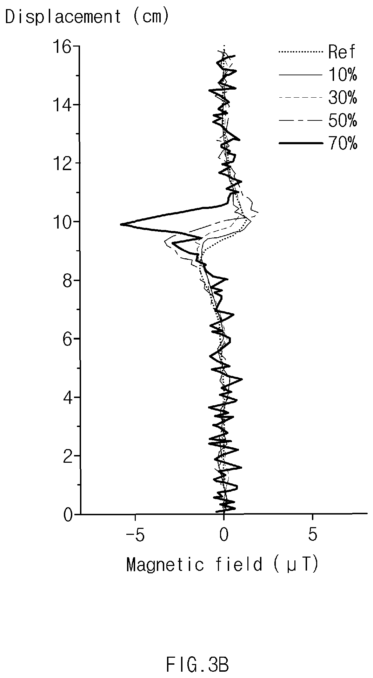

In order to help understanding the magnetic field linear data, an example will be described with reference to FIG. 3b. Referring to FIG. 3b, it can be confirmed that, at a specific location (e.g., 1.3 cm) among the transverse displacements, the magnetic field linear data for a longitudinal section (e.g., 0 cm to 16 cm). Specifically, it can be confirmed that the magnetic field linear data calculated based on the magnetic field images that are respectively acquired for a normal battery cell Ref, a battery cell having an electrode tab torn by approximately 10%, a battery cell having an electrode tab torn by approximately 30%, a battery cell having an electrode tab torn by approximately 50%, and a battery cell having an electrode tab torn by approximately 70%.

For reference, a longitudinal displacement section of 0 cm to 8 cm in FIG. 3a corresponds to a longitudinal displacement section of 5 cm to 13 cm in FIG. 3b. This is because a longitudinal length (e.g., 16 cm) sensed by the magnetic field sensor array illustrated in FIG. 2a exceeds a longitudinal length (e.g., 8 cm) of the battery cell.

When a defect occurs in the battery cell, a magnetic field drift or deficiency phenomenon occurs at a location where the defect occurs. As illustrated in FIG. 3b, in the case of the normal battery cell, since the magnetic field drift or deficiency phenomenon does not occur, a negative peak and a positive peak are symmetrically formed based on a magnetic field intensity of 0 µT near a longitudinal displacement of 9 cm, whereas in the case of a defective battery cell, the peaks are formed asymmetrically. In addition, as a defect level increases, the asymmetry of the peaks becomes greater, and it can be confirmed that the longitudinal displacement where the magnetic field intensity between the negative peak and the positive peak satisfies 0 µT tends to move in a specific direction (e.g., a direction in which the displacement increases). Therefore, the magnetic field asymmetry may be analyzed through the magnetic field linear data, and based on this, an abnormality of the battery cell may be diagnosed.

According to an embodiment, the processor 120 may acquire a k-th representative magnetic field intensity corresponding to a k-th displacement along a reference direction within the monitoring area based on a plurality of k-th displacement magnetic field intensities of the k-th displacement, and calculate magnetic field linear data by referring to a first representative magnetic field intensity to an n-th representative magnetic field intensity including the k-th representative magnetic field intensity. For example, the processor 120 may acquire an average value of a plurality of magnetic field intensities at a displacement of 4 cm along the longitudinal direction within the monitoring area as a representative magnetic field intensity corresponding to the displacement of 4 cm, perform the same process for all displacements (e.g., 0 cm to 16 cm) along the longitudinal direction within the monitoring area to acquire the first representative magnetic field intensity to the n-th representative magnetic field intensity that correspond to the first displacement (e.g., 0 cm) to the n-th displacement (e.g., 16 cm) along the longitudinal direction, and calculate magnetic field linear data by referring to this.

According to an embodiment, the processor 120 may input magnetic field linear data into a defect level estimation model and diagnose an abnormality of the battery cell based on an estimated defect level output from the defect level estimation model.

In this case, the defect level estimation model may be a deep learning model for which training is completed using training data.

According to an embodiment, the defect level estimation model may output an estimated defect level for training corresponding to magnetic field linear data for training when the magnetic field linear data for training is acquired and output the estimated defect level (e.g., the estimated defect level for testing) corresponding to the magnetic field linear data when the magnetic field linear data (e.g., the magnetic field linear data for testing) is acquired in a state where at least some of parameters of the defect level estimation model are updated based on an error generated using the estimated defect level for training and a correct defect level corresponding thereto. For example, if magnetic field linear data for training representing a 30% tab tear defect is input to a defect level estimation model and the defect level estimation model outputs an estimated defect level for training (e.g., 20%), a process of generating an error (e.g., 10%) using the estimated defect level for training (e.g., 20%) and the correct defect level (e.g., 30%), and updating at least some of the parameters of the defect level estimation model based on the error can be performed.

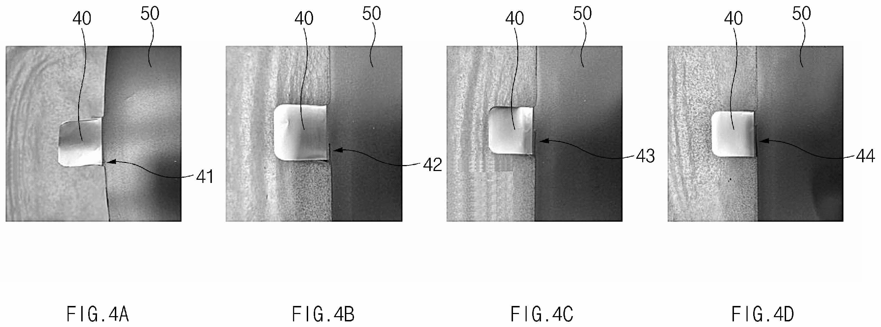

FIGS. 4a to 7b are diagrams for describing a process of constructing a training set set.

First, referring to FIGS. 4a to 4d, it can be confirmed that images representing various defect levels in relation to tab 40 tearing of an electrode 50. Specifically, referring to FIG. 4a, it can be confirmed that a portion 41 torn by approximately 10% of an electrode 50-and-tab 40 connection area, referring to FIG. 4b, it can be confirmed that a portion 42 torn by approximately 30% of the electrode 50-and-tab 40 connection area, referring to FIG. 4c, it can be confirmed that a portion 43 torn by approximately 50% of the electrode 50-and-tab 40 connection area, and referring to FIG. 4d, it can be confirmed that a portion 44 torn by approximately 70% of the electrode 50-and-tab 40 connection area.

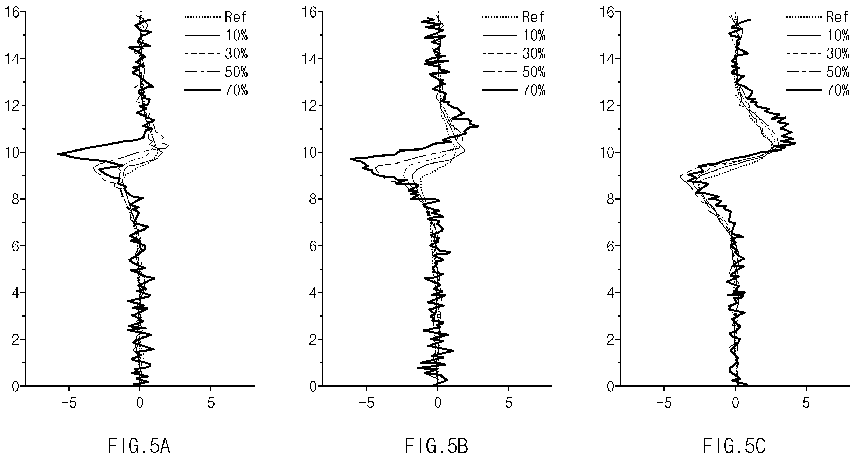

In addition, referring to FIG. 5, it can be confirmed that the magnetic field linear data calculated based on the magnetic field images generated through the magnetic field sensor array for the battery cells of FIGS. 4a to 4d in which various levels of tab tearing defects occurred in order to construct a training data set.

For reference, in the magnetic field linear data of FIGS. 5a to 5c, the horizontal axis corresponds to the magnetic field intensity µT and the vertical axis corresponds to the longitudinal displacement cm at a specific transverse location of the battery cell. Specifically, FIG. 5a shows magnetic field linear data corresponding to the magnetic field intensity at each longitudinal displacement (0 cm to 16 cm) at any tab 40 location (e.g., transverse displacement of 1 cm) excluding the location where the tab tearing occurred of the tab 40 area of the battery cell, FIG. 5b shows magnetic field linear data corresponding to the magnetic field intensity at each longitudinal displacement (0 cm to 16 cm) at any location where the tab tearing occurred (e.g., transverse displacement of 1.5 cm), and FIG. 5c shows magnetic field linear data corresponding to the magnetic field intensity at each longitudinal displacement (0 cm to 16 cm) at any location (e.g., transverse displacement of 2 cm) of the electrode 50 area other than the tab 40 area.

First, referring to FIG. 5a, since it corresponds to magnetic field linear data calculated based on magnetic field images near the location where the defect occurred (e.g., transverse displacement of 1.5 cm), it can be confirmed that four magnetic field linear data (e.g., peaks) corresponding to the remaining battery cells excluding the normal battery cell Ref exhibit asymmetry. In addition, as described above, it can be confirmed that, as the defect level increases, the asymmetry of the peaks increases, and the longitudinal displacement at which the magnetic field intensity between the negative peak and the positive peak satisfies 0µT tends to move in a specific direction (e.g., the direction in which the displacement increases).

In addition, referring to FIG. 5b, since it corresponds to magnetic field linear data calculated based on magnetic field images at the location where the defect occurred (e.g., transverse displacement of 1.5 cm), it can be confirmed that the asymmetry of the magnetic field linear data is greater than that of FIG. 5a.

On the other hand, referring to FIG. 5c, since it corresponds to magnetic field linear data calculated based on magnetic field images at the electrode 50 other than the location where the defect occurred (tab; 40), it can be confirmed that the magnetic field linear data Ref corresponding to the normal battery cell and the magnetic field linear data 10%, 30%, 50%, and 70% corresponding to the defective battery cell are similar to each other and asymmetry is small.

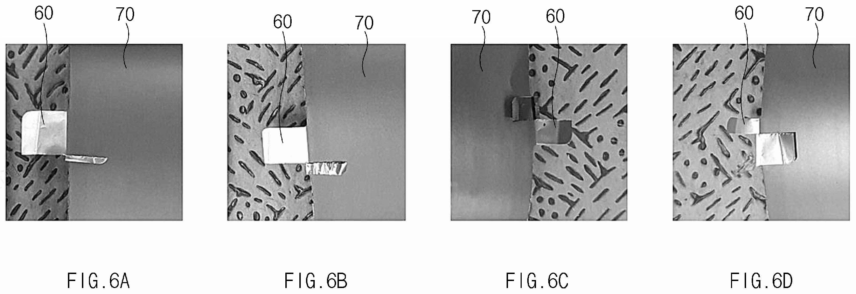

In addition, referring to FIGS. 6a to 6d, it can be confirmed that images showing various defect levels in relation to partial folding defects of a tab 60 connected to an electrode 70. Specifically, FIG. 6a shows the tab 60 folded by approximately 10%, FIG. 6b shows a tab 60 folded by approximately 30%, FIG. 6c shows a tab 60 folded by approximately 50%, and FIG. 6d shows a tab 60 folded by approximately 70%.

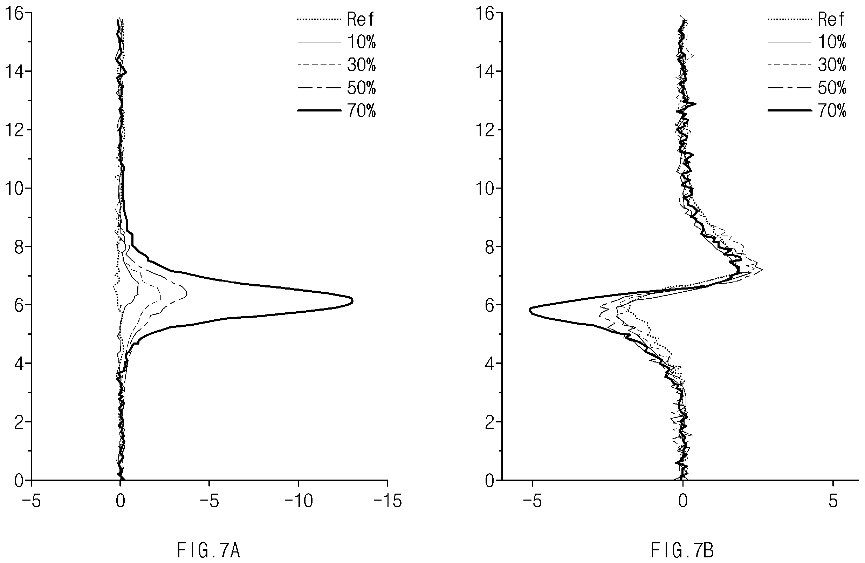

In addition, referring to FIGS. 7a and 7b, it can be confirmed that magnetic field linear data calculated based on magnetic field images generated through a magnetic field sensor array for the battery cells of FIGS. 6a to 6d in which various levels of partial folding defects of the tabs occurred in order to construct a training data set.

For reference, in the magnetic field linear data of FIGS. 7a and 7b, the horizontal axis corresponds to the magnetic field intensity µT, and the vertical axis corresponds to the longitudinal displacement cm at a specific transverse location of the battery cell. Specifically, FIG. 7a shows magnetic field linear data corresponding to the magnetic field intensity longitudinal displacement (0 cm to 16 cm) at each longitudinal displacement at a location where a partial folding of the tab 60 occurred (e.g., transverse displacement of 1 cm), and FIG. 7b shows magnetic field linear data corresponding to the magnetic field intensity at each longitudinal displacement (0 cm to 16 cm) at any location (e.g., transverse displacement of 2 cm) of the electrode 70 area other than the tab 60 area.

First, referring to FIG. 7a, since it corresponds to the magnetic field linear data calculated based on the magnetic field image at the location where a defect occurred (e.g., transverse displacement of 1 cm), it can be confirmed that four magnetic field linear data (e.g., peaks) corresponding to the remaining battery cells excluding the normal battery cell Ref exhibit asymmetry. In addition, as described above, it can be confirmed that, as the defect level increases, the asymmetry increases, such as a peak occurring only in one direction.

On the other hand, referring to FIG. 7b, since it corresponds to the magnetic field linear data calculated based on the magnetic field image at the electrode 70 other than the location (tab; 60) where the defect occurred, it can be confirmed that, except in the case where the tab 60 is extremely partially folded (e.g., 70%), there is almost no difference between the magnetic field linear data Ref corresponding to the normal battery cell and the magnetic field linear data 10%, 30%, and 50% corresponding to the defective battery cell.

For reference, in the above, the process of constructing a training data set for learning various defect levels for the tab tearing defect type and the tab partial folding defect type has been described, but this is only an example to help understanding, and the defect types of which defect levels are diagnosed by the battery diagnosis device 100 according to an embodiment disclosed in this document are not limited to the example described above. For example, even for the electrode misalignment defect type, a training data set corresponding to various degrees of electrode misalignment may be constructed and used to train a defect level estimation model.

According to an embodiment, the processor 120 may input a magnetic field image into the defect type estimation model, and may diagnose the abnormality of the battery cell based on the estimated defect level output from the defect level estimation model and the estimated defect type output from the defect type estimation model. For example, the processor 120 may diagnose that a 30% level of tab partial folding defect has occurred in the battery cell based on the estimated defect level and the estimated defect type.

In this case, the defect type estimation model may be a deep learning model for which training has been completed using a training data set.

According to an embodiment, the defect level estimation model may output an estimated defect level for training corresponding to a magnetic field image for training when the magnetic field image for training is acquired and output an estimated defect type (e.g., an estimated defect type for testing corresponding to a magnetic field image (e.g., a magnetic field image for testing) when the magnetic field image is acquired in a state where at least some of parameters of the defect level estimation model are updated based on an error generated using the estimated defect type for training and a correct answer defect type corresponding thereto.

According to an embodiment, the processor 120 may calculate at least one magnetic field linear data based on at least some of the first magnetic field component image to the third magnetic field component image, and may diagnose an abnormality of the battery cell based on at least some of the at least one magnetic field linear data.

For example, when the processor 120 calculates magnetic field linear data (e.g., first magnetic field linear data) based on a magnetic field image corresponding to a first magnetic field component and calculates magnetic field linear data (e.g., second magnetic field linear data) based on a magnetic field image corresponding to a second magnetic field component, the processor 120 may diagnose the abnormality of the battery cell based on at least some of the first magnetic field linear data and the second magnetic field linear data.

As an example, the processor 120 may diagnose the abnormality of the battery cell based on any one of a plurality of magnetic field linear data.

As another example, the processor 120 may diagnose the abnormality of the battery cell based on all of the plurality of magnetic field linear data. For example, for a specific battery cell, when the defect level estimation result based on the first magnetic field linear data is 40% and the defect level estimation result based on the second magnetic field linear data is 20%, the processor 120 may determine one of the maximum value, minimum value, and average value among 40% and 20% as the defect level estimation result.

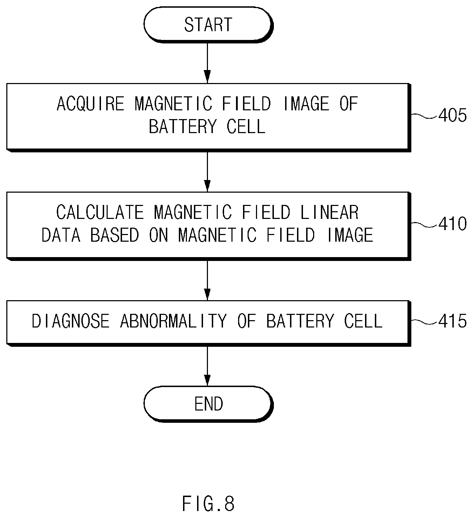

FIG. 8 is a flowchart of the operation of the battery diagnosis device 100 according to an embodiment. FIG. 8 may correspond to a description of the operation of the battery diagnosis device 100 of FIG. 1, and may be described using the configuration of FIG. 1.

The embodiment illustrated in FIG. 8 is only an embodiment, and the order of steps according to various embodiments of the present invention may be different from that illustrated in FIG. 8, and some steps illustrated in FIG. 8 may be omitted, the order between steps may be changed, or steps may be merged.

Referring to FIG. 8, in operation 405, the battery diagnosis device 100 may acquire a magnetic field image of a battery cell.

In operation 410, the battery diagnosis device 100 may calculate magnetic field linear data corresponding to the magnetic field intensity of a specific location of the battery cell based on the magnetic field image acquired in operation 405. According to an embodiment, the battery diagnosis device 100 may determine a monitoring area including a specific location on a magnetic field image, and may calculate magnetic field linear data by referring to the magnetic field intensity in the monitoring area. According to an embodiment, the battery diagnosis device 100 may calculate magnetic field linear data by referring to a plurality of first displacement magnetic field intensities to a plurality of nth displacement magnetic field intensities of the first displacement to the n-th displacement along a reference direction within the monitoring area. According to an embodiment, the battery diagnosis device 100 may acquire a k-th representative magnetic field intensity corresponding to a k-th displacement based on a plurality of k-th displacement magnetic field intensities of the k-th displacement along the reference direction within the monitoring area, and calculate magnetic field linear data by referring to a first representative magnetic field intensity to an n-th representative magnetic field intensity including the k-th representative magnetic field intensity. According to an embodiment, the battery diagnosis device 100 includes an operation of calculating magnetic field linear data based on at least some of a first magnetic field component image to a third magnetic field component image included in a magnetic field image, and the first magnetic field component to the third magnetic field component that respectively correspond to the first magnetic field component image to the third magnetic field component image may be orthogonal to one another.

In operation 415, the battery diagnosis device 100 may diagnose an abnormality of the battery cell based on the magnetic field linear data calculated in operation 410. According to an embodiment, the battery diagnosis device 100 may input the magnetic field linear data into a defect level estimation model, and diagnose the abnormality of the battery cell based on an estimated defect level output from the defect level estimation model. According to an embodiment, an operation of inputting magnetic field linear data for training into a defect level estimation model, generating an error using the estimated defect level for training output from the defect level estimation model and a correct defect level corresponding thereto, and updating at least some of the parameters of the defect level estimation model based on the error may be performed. According to an embodiment, the battery diagnosis device 100 may input the magnetic field image into the defect type estimation model, and diagnose the abnormality of the battery cell based on the estimated defect level and an estimated defect type output from a defect type estimation model.

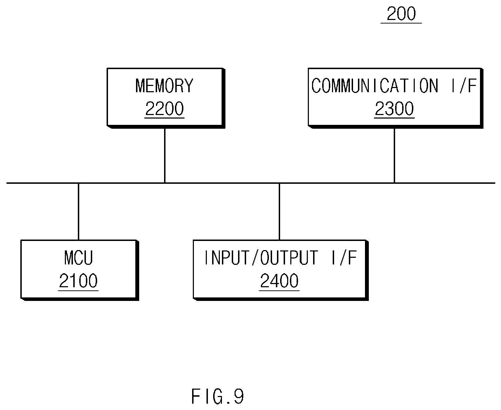

FIG. 9 shows a computing system executing an operating method of the battery diagnosis device 100 according to an embodiment disclosed in this document.

Referring to FIG. 5, a computing system 2000 according to an embodiment disclosed in this document may include an MCU 2010, a memory 2200, an input/output I/F 2300, and a communication I/F 2400.

The MCU 2100 may be a processor that executes various programs (e.g., the battery diagnosis programs) stored in the memory 2200 and performs the functions of the battery diagnosis device 100 described with reference to FIG. 1 described above, or a processor that executes the operating method of the battery diagnosis device described with reference to FIG. 8.

The memory 2200 may store a magnetic field image of a battery cell, magnetic field linear data, a battery fastening failure judgment program, a battery data transmission program, a battery diagnosis program, etc.

A plurality of such memories 2200 may be provided as needed. The memory 2200 may be a volatile memory or a nonvolatile memory. The memory 2200 used as the volatile memory may be RAM, DRAM, SRAM, etc. The memory 2200 used as the nonvolatile memory may be ROM, PROM, EAROM, EPROM, EEPROM, flash memory, etc. The examples of the memories 2200 listed above are only examples and are not limited to these examples.

The input/output I/F 2400 may provide an interface that allows data to be transmitted and received by connecting an input device (not shown) such as a keyboard, mouse, or touch panel and an output device such as a display (not shown) with the MCU 2100.

The communication I/F 2300 is a configuration that can transmit and receive various data with the server, and may be various devices that can support wired or wireless communication. For example, a magnetic field image of a battery cell may be transmitted and received to and from an external server separately prepared through the communication I/F 2300.

In this way, the operating method of the battery diagnosis device according to an embodiment disclosed in this document may be recorded in the memory 2200 and executed by the MCU 2100.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

## Claims

1. A battery diagnosis device comprising:
an interface configured to acquire a magnetic field image of a battery cell; and
one or more processors configured to generate magnetic field linear data corresponding to a magnetic field intensity at a specific location of the battery cell based on the magnetic field image and diagnose an abnormality of the battery cell based on the magnetic field linear data.

2. The battery diagnosis device of claim 1, wherein the one or more processors is configured to determine a monitoring area including the specific location on the magnetic field image and calculate the magnetic field linear data by referring to the magnetic field intensity in the monitoring area.

3. The battery diagnosis device of claim 2, wherein the one or more processors is configured to calculate the magnetic field linear data by referring to a plurality of first displacement magnetic field intensities to a plurality of n-th displacement magnetic field intensities of a first displacement to an n-th displacement along a reference direction within the monitoring area.

4. The battery diagnosis device of claim 3, wherein the one or more processors is configured to:
acquire a k-th representative magnetic field intensity corresponding to a k-th displacement along the reference direction within the monitoring area based on a plurality of k-th displacement magnetic field intensities of the k-th displacement; and
calculate the magnetic field linear data by referring to a first representative magnetic field intensity to an n-th representative magnetic field intensity including the k-th representative magnetic field intensity.

5. The battery diagnosis device of claim 1, wherein the one or more processors is configured to calculate the magnetic field linear data based on at least some of a first magnetic field component image to a third magnetic field component image included in the magnetic field image, and
a first magnetic field component to a third magnetic field component that respectively correspond to the first magnetic field component image to the third magnetic field component image may be orthogonal to one another.

6. The battery diagnosis device of claim 1, wherein the one or more processors is configured to input the magnetic field linear data into a defect level estimation model, and diagnose an abnormality of the battery cell based on an estimated defect level output from the defect level estimation model.

7. The battery diagnosis device of claim 6, wherein the defect level estimation model is configured to output an estimated defect level for training corresponding to magnetic field linear data for training when the magnetic field linear data for training is acquired and output the estimated defect level in a state where at least some of parameters of the defect level estimation model are updated based on an error generated using the estimated defect level for training and a correct defect level corresponding thereto.

8. The battery diagnosis device of claim 6, wherein the one or more processors is configured to input the magnetic field image into a defect type estimation model and diagnose an abnormality of the battery cell based on the estimated defect level and an estimated defect type output from the defect type estimation model.

9. The battery diagnosis device of claim 1, wherein the battery cell is a pouch cell.

10. A battery diagnosis method comprising:
an operation of acquiring a magnetic field image of a battery cell;
an operation of generating magnetic field linear data corresponding to a magnetic field intensity at a specific location of the battery cell based on the magnetic field image; and
an operation of diagnosing an abnormality of the battery cell based on the magnetic field linear data.

11. The battery diagnosis method of claim 10, wherein the operation of calculating the magnetic field linear data includes an operation of determining a monitoring area including the specific location on the magnetic field image and calculating the magnetic field linear data by referring to the magnetic field intensity in the monitoring area.

12. The battery diagnosis method of claim 11, wherein the operation of calculating the magnetic field linear data includes an operation of calculating the magnetic field linear data by referring to a plurality of first displacement magnetic field intensities to a plurality of n-th displacement magnetic field intensities of a first displacement to an n-th displacement along a reference direction within the monitoring area.

13. The battery diagnosis method of claim 12, wherein the operation of calculating the magnetic field linear data includes an operation of acquiring a k-th representative magnetic field intensity corresponding to a k-th displacement along the reference direction within the monitoring area based on a plurality of k-th displacement magnetic field intensities of the k-th displacement; and calculating the magnetic field linear data by referring to a first representative magnetic field intensity to an n-th representative magnetic field intensity including the k-th representative magnetic field intensity.

14. The battery diagnosis method of claim 10, wherein the operation of calculating the magnetic field linear data includes an operation of calculating the magnetic field linear data based on at least some of a first magnetic field component image to a third magnetic field component image included in the magnetic field image, and
a first magnetic field component to a third magnetic field component that respectively correspond to the first magnetic field component image to the third magnetic field component image may be orthogonal to one another.

15. The battery diagnosis method of claim 10, wherein the operation of diagnosing the abnormality of the battery cell includes an operation of inputting the magnetic field linear data into a defect level estimation model, and diagnosing an abnormality of the battery cell based on an estimated defect level output from the defect level estimation model.

16. The battery diagnosis method of claim 15, further comprising:
prior to the operation of diagnosing the abnormality of the battery cell,
an operation of inputting magnetic field linear data for training into the defect level estimation model, generating an error using an estimated defect level for training output from the defect level estimation model and a correct defect level corresponding thereto, and updating at least some of parameters of the defect level estimation model based on the error.

17. The battery diagnosis method of claim 15, wherein the operation of diagnosing the abnormality of the battery cell includes an operation of inputting the magnetic field image into a defect type estimation model, and diagnosing the abnormality of the battery cell based on the estimated defect level and an estimated defect type output from the defect type estimation model.
